# FASCICULE DE BREVET EUROPEEN

(11) **EP 1 000 420 B1**
(45) Date de publication et mention de la délivrance du brevet: **11.12.2002**
(21) Numéro de dépôt: 99920922.4
(22) Date de dépôt: 26.05.1999
(51) Int. Cl.: G08B 13/26, H03K 17/945

(54) **DISPOSITIF DE DETECTION DE PRESENCE D'UN CORPS HUMAIN**
VORRICHTUNG ZUR ERFASSUNG DER ANWESENHEIT EINES MENSCHLICHEN KÖRPERS
DEVICE FOR DETECTING A HUMAN BODY

(30) Priorité: 26.05.1998 IT TO980452
(43) Date de publication de la demande: 17.05.2000
(73) Titulaire: VALEO SECURITE HABITACLE, 94000 Créteil (FR)
(72) Inventeur: ZANNIER, Gian, Carlo, I-10098 Rivoli (IT)
(74) Mandataire: Croonenbroek, Thomas
(86) Numéro de dépôt international: FR9901230
(87) Numéro de publication internationale: WO99062040

(56) Documents cités:
- EP-A- 0 298 331
- EP-A- 0 334 531
- EP-A- 0 770 749
- DE-A- 3 100 936
- FR-A- 2 194 008
- US-A- 4 305 021
- K. E. POWELL: "Screening sensor circuit arrangement" IBM TECHNICAL DISCLOSURE BULLETIN, vol. 24, no. 9, février 1982 (1982-02), page 4462 XP002115954

## Description

La présente invention concerne un dispositif de détection de présence d'un corps humain.

En particulier, la présente invention trouve une application avantageuse, mais non exclusive, dans le domaine de l'automobile pour permettre à un utilisateur de commander de façon « mains libres », sans avoir recours à une télécommande qu'il devrait actionner, l'ouverture automatique des serrures des portières d'un véhicule au moment où il approche de celui-ci, et notamment par exemple lorsqu'il saisit la poignée extérieure d'une portière.

On connaît actuellement plusieurs solutions pour la détection de la présence de la main d'une personne. Parmi les principales, les plus connues sont basées les unes sur la détection capacitive, à savoir, sur la variation de la capacité d'un condensateur due à son effleurement par un doigt de la personne, les autres sur des principes de détection de proximité, par exemple, par effet Doppler, par interruption d'un faisceau lumineux, par détection de chaleur, etc.

Les solutions connues exigent cependant une implémentation de circuits complexe et coûteuse et s'avèrent difficiles à mettre en oeuvre dans le domaine de l'automobile.

On connaît par ailleurs du document US 3 774 110 un dispositif de détection de présence comportant une antenne et des moyens oscillateurs comportant en série un étage d'amplification et un étage de résonance, dans lequel les moyens oscillateurs sont mis en fonctionnement lorsque l'antenne détecte un champ électrique, permettant ainsi de conclure à la présence d'une personne.

L'objet de la présente invention est de réaliser un dispositif de détection de présence qui soit simple et économique.

A cet effet l'invention propose un dispositif de détection de présence tel que défini dans la revendication 1.

Ce dispositif est avantageusement complété par les différentes caractéristiques suivantes prises seules ou selon toutes leurs combinaisons techniquement possibles :
- l'étage d'amplification du dispositif assure à l'oscillateur un gain de l'ordre de ou supérieur à 10⁵, pour au moins une fréquence comprise entre 100 et 500 Hz ;
- une entrée de l'étage amplificateur est reliée à la sortie des moyens de réception par l'intermédiaire de premiers moyens résistifs et l'étage amplificateur comporte au moins une branche qui est montée en parallèle par rapport audits moyens résistifs et qui comprend au moins trois inverseurs logiques en cascade ;
- les inverseurs logiques sont des amplificateurs formant portes logiques inverseuses, présentant un montage de type « push-pull » en sortie ;
- des deuxièmes moyens résistifs sont montés entre la sortie des moyens de réception et les trois inverseurs logiques en cascade ;
- les valeurs de la résistance des premiers moyens résistifs et de la résistance des seconds moyens résistifs sont telles qu'au moins le premier inverseur logique fonctionne en mode non saturé ;
- le (ou les) inverseur(s) logique(s) non saturé(s) sont suivi(s) par au moins une paire d'inverseurs logiques saturés ;
- des moyens résistifs sont montés en parallèle aux bornes de chacun des inverseurs logiques en cascade ;
- les moyens de traitement comportent des moyens comparateurs destinés à comparer à un seuil prédéterminé la valeur moyenne d'un signal caractéristique de la variation de fréquence du signal en sortie de l'étage amplificateur ;
- l'étage de résonance comprend des moyens inverseurs logiques placés entre l'entrée et la sortie desdits moyens oscillateurs, ainsi que des moyens capacitifs et résistifs montés en série entre la sortie desdits moyens de réception et la sortie de l'étage amplificateur ;
- les moyens de traitement comprennent des moyens intégrateurs montés en sortie de l'étage amplificateur ;
- lesdits moyens intégrateurs comprennent des moyens inverseurs logiques ayant une entrée reliée à l'entrée desdits moyens intégrateurs par l'intermédiaire de moyens interrupteurs unipolaires, ainsi que des moyens capacitifs montés entre l'entrée desdits moyens inverseurs logiques et une ligne de masse ;
- lesdits moyens intégrateurs comprennent, de plus, des moyens résistifs de type variable placés entre l'entrée desdits cinquièmes moyens inverseurs logiques et ladite ligne de masse ;
- les moyens comparateurs comprennent des moyens inverseurs logiques ayant une entrée reliée à l'entrée desdits moyens comparateurs à travers de moyens interrupteurs unipolaires, des moyens capacitifs montés entre une ligne d'alimentation et l'entrée desdits moyens inverseurs logiques, des moyens résistifs montés en série avec des moyens interrupteurs unipolaires entre l'entrée desdits moyens inverseurs logiques et la ligne de masse ;
- les moyens comparateurs comportent un montage comparateur à seuil adaptatif ;
- les moyens de réception comportent des moyens pour le filtrage des perturbations dues à des effets capacitifs.

L'invention concerne également un dispositif qui comprend :
- des moyens pour la réception d'un champ électromagnétique intrinsèque rayonné par le corps humain,
- des moyens pour amplifier et convertir le champ électromagnétique reçu sur lesdits moyens de réception, qui génèrent un signal dont au moins un paramètre est corrélé avec l'intensité dudit champ électromagnétique reçu,
- des moyens comparateurs qui reçoivent en entrée ledit signal et qui comparent ledit paramètre à une valeur de seuil caractéristique de la détection d'une présence.

Elle concerne en outre un système de déverrouillage d'ouvrants de véhicule, notamment automobile, de type « mains libres », comportant un dispositif de détection de présence et des moyens pour l'émission d'un signal d'interrogation qui sont réveillés lorsque le dispositif détecte la présence d'un individu, ledit dispositif étant un dispositif de détection de présence du type précité.

Pour mieux comprendre la présente invention, un mode de réalisation préféré va être décrit, donné à titre d'exemple non limitatif, et en références aux dessins annexés, dans lesquels :
- la figure 1a représente un schéma de circuit d'un dispositif de détection de la présence du corps humain selon la présente invention ;
- la figure 1b illustre un montage à seuil adaptatif qui peut être intégré dans un dispositif du type de celui de la figure 1a ;
- les figures 2 à 7 représentent des courbes temporelles de grandeurs électriques du dispositif de détection de la figure 1a.

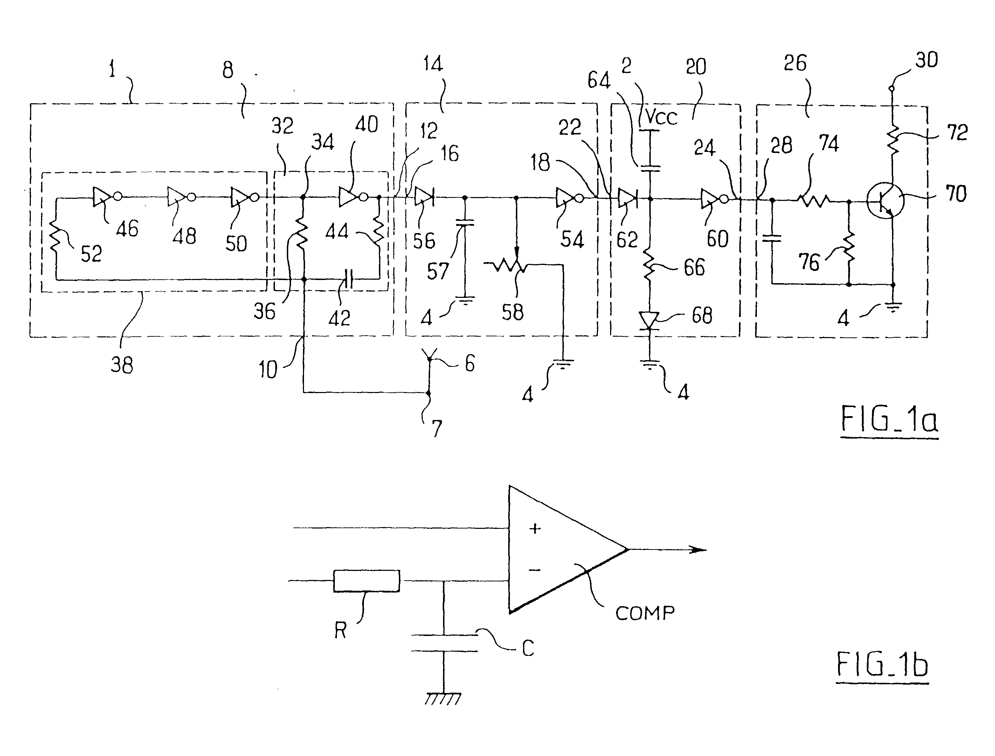

Le dispositif de détection représenté sur la figure 1a, référencé par 1 dans son ensemble, comprend une ligne d'alimentation 2 qui est à un potentiel de référence V_{cc} prédéterminé ; une ligne de masse 4 ; des moyens de réception comportant principalement une antenne 6 qui est logée par exemple dans une poignée extérieure du véhicule et qui fournit sur une sortie 7 un signal de perturbation, tel que mieux décrit par la suite ; un circuit oscillateur 8 ayant une entrée 10 reliée à la sortie 7 de l'antenne 6 et une sortie 12 sur laquelle ledit oscillateur fourni un signal de type alterné ; un circuit intégrateur 14 ayant une entrée 16 reliée à la sortie 12 du circuit oscillateur 8 et une sortie 18 sur laquelle ledit circuit 14 fourni un signal d'information également de type alterné ; un circuit comparateur 20 ayant une entrée 22 reliée à la sortie 18 du circuit intégrateur 14 et une sortie 24 sur laquelle ledit circuit délivre un signal de présence de type logique révélateur du résultat de la comparaison entre le signal d'information et une valeur de seuil ; et un circuit de sortie 26 ayant une entrée 28 reliée à la sortie 24 du circuit comparateur 20 et une sortie 30 sur laquelle ledit circuit de sortie fourni un signal de commande qui est utilisé de la façon qui est décrite plus loin de façon détaillée.

Le circuit oscillateur 8 comprend un étage de résonance 32 de type connu ayant une fréquence d'oscillation nominale prédéterminée fonction des valeurs de ses composants constitutifs et ayant une entrée 34 reliée à l'entrée 10 par une résistance 36 et une sortie reliée à la sortie 12.

Le circuit 8 comporte également un étage amplificateur de perturbation 38 monté entre l'entrée 10 et l'entrée 34 de l'étage de résonance 32, en parallèle à la résistance 36.

Cet étage amplificateur 38 a pour but d'injecter dans l'étage de résonance 32 même le signal de perturbation fourni par l'antenne 6 afin de provoquer une excursion de la fréquence d'oscillation de l'étage de résonance 32 même par rapport à sa valeur nominale.

Plus particulièrement, l'étage de résonance 32 comprend un inverseur logique 40 dont l'entrée est reliée à l'entrée 34 et dont la sortie est reliée à la sortie 12 ; ledit étage de résonance 32 comporte également un condensateur 42 et une résistance 44 montés en série entre l'entrée 10 et la sortie 12.

La valeur capacitive du condensateur 42 est par exemple de 15 pF, tandis que la résistance 44 a une valeur de l'ordre de 1 à 10 MΩ.

L'étage amplificateur de perturbation 38 comprend trois inverseurs logiques 46, 48, 50. Ces trois inverseurs sont montés en cascade, la sortie de l'inverseur 46 étant reliée à l'entrée de l'inverseur 48, la sortie de l'inverseur 48 étant reliée à l'entrée de l'inverseur 50. L'entrée de l'inverseur 46 est quant à elle reliée par une résistance 52 à l'entrée 10, tandis que la sortie de l'inverseur 50 est reliée à l'entrée 34 de l'étage de résonance 32.

Les inverseurs logiques 46, 48 et 50 sont - comme l'inverseur logique 40 de l'étage de résonance 32 - des amplificateurs formant portes logiques inverseuses, présentant un montage « push-pull » en sortie. Plus particulièrement, ces inverseurs logiques sont des portes logiques CD4049UB ou CD4069UB.

La résistance 52 présente quant à elle une valeur résistive de l'ordre de 1 à 10 MΩ. Il en est de même de la résistance 36.

Avec un tel montage, l'étage amplificateur 38 permet d'amplifier avec un gain de 10⁶ au moins certains signaux ayant une fréquence comprise entre 100 et 500 Hz et notamment des signaux ayant une fréquence comprise entre 150 et 300 Hz.

Du fait du montage en boucle assuré par la résistance 36 et la résistance 52, la porte logique 46 fonctionne alors non pas en tout ou rien, mais selon son mode de transition linéaire entre les deux niveaux que sa sortie peut prendre.

Les portes 48 et 50 fonctionnent quant à elles selon leurs modes saturés.

Ceci assure le gain élevé précité.

D'autres variantes de réalisation pourraient encore être envisagées.

En particulier, le montage en cascade pourrait comporter un nombre plus important de portes logiques. Dès lors que les portes fonctionnant selon leur mode de transition sont suivies par un nombre pair de portes logiques inverseuses saturées, le gain du montage est très important.

Le circuit intégrateur 14 comprend quant à lui un inverseur logique 54, qui est également une porte logique CD4049UB ou CD4069UB. L'entrée dudit inverseur 54 est reliée à l'entrée 12 du circuit intégrateur 14 par une diode 56, tandis que sa sortie est reliée à la sortie 18 du circuit intégrateur 14. Un condensateur 57 - par exemple de 130 pF - est monté entre l'entrée de l'inverseur logique 54 et la ligne de masse 4. Une résistance 58 de type variable est montée en parallèle audit condensateur 56. Cette résistance 58 est par exemple constituée d'une résistance de 680 kΩ et d'une résistance de 47 kΩ montées en série avec une résistance de 2,2 MΩ aux bornes de laquelle est montée en parallèle une résistance variable dont la valeur résistive peut varier entre 0 et 10MΩ.

La diode 56 est passante de l'entrée 16 vers la porte logique 54, son anode étant reliée à l'entrée 16 du circuit intégrateur 14, tandis que sa cathode est reliée à l'entrée de l'inverseur logique 54.

Le circuit comparateur 20 comprend un inverseur logique 60, qui est identique aux inverseurs logiques 46, 48, 50 et 54 et dont une entrée est reliée à l'entrée 22 du circuit comparateur 20 par une diode 62. Le comparateur 20 comporte également un condensateur 64 monté entre la ligne d'alimentation 2 et l'entrée de l'inverseur logique 60, ainsi qu'une résistance 66 et une diode 68 montées en série entre l'entrée de l'inverseur logique 60 et la ligne de masse 4.

Plus particulièrement, la diode 62 est reliée par son anode à l'entrée 22 du circuit comparateur 20 et par sa cathode à l'entrée de l'inverseur logique 60. L'anode de la diode 68 est reliée, par la résistance 66, à l'entrée de l'inverseur logique 60, sa cathode étant reliée à la ligne de masse 4.

La valeur capacitive du condensateur 64 est de 100 nF, tandis que la valeur résistive de la résistance 66 est par exemple de 1MΩ.

Un tel dimensionnement, notamment du condensateur 64, permet de faire en sorte que lorsque l'étage de résonance 32 présente une fréquence d'oscillation égale à la fréquence d'oscillation nominale, l'entrée de l'inverseur logique 60 est placée à une tension prédéterminée supérieure à la tension de seuil de commutation de l'inverseur logique 60 . De ce fait, le signal de présence présent sur la sortie de cet inverseur prend un niveau logique bas. La valeur de la tension de l'entrée de l'inverseur logique 60 lorsque l'étage de résonance 32 présente une fréquence d'oscillation égale à sa propre fréquence d'oscillation nominale définit, comme cela sera expliqué en détail ci-après, la valeur de seuil avec laquelle est comparé le signal d'information fourni par le circuit intégrateur 14.

Le circuit de sortie 26 comprend un transistor bipolaire 70 de type NPN ayant la borne de collecteur reliée, par une résistance 72, à la sortie 30 du circuit de sortie 26 même, la borne d'émetteur reliée à la ligne de masse 4 et la borne de base reliée, par une résistance 74, à l'entrée 28 du circuit de sortie 26 même.

Le circuit de sortie 26 comprend, en plus, une résistance 76 placée entre la borne de base et la borne d'émetteur du transistor bipolaire 70 et un condensateur 78 placé entre l'entrée 28 du circuit de sortie 26 et la borne d'émetteur du transistor bipolaire 70.

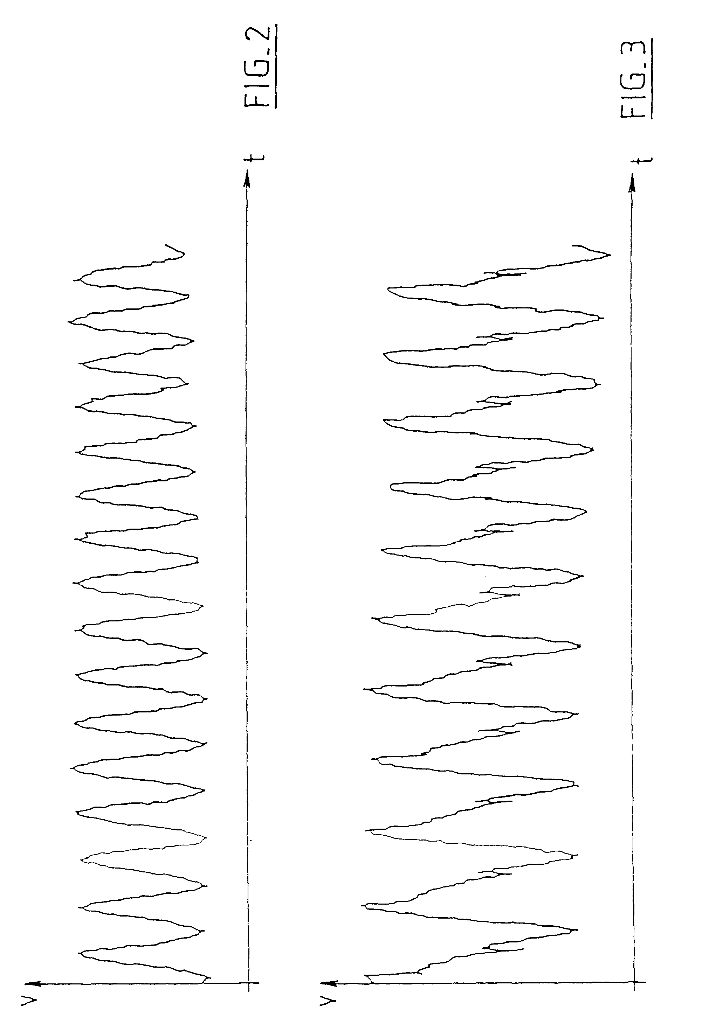

il a été constaté qu'avec des montages du type de celui proposé par l'invention et notamment avec un montage du type de celui décrit en référence aux figures 1 et 2, un signal de perturbation est généré dans l'étage de résonance 32 via l'antenne 6 et l'étage amplificateur 38 lorsqu'un individu se tenait à proximité immédiate de l'antenne 6, et notamment lorsqu'il disposait sa main à proximité de ladite antenne 6.

Le signal de perturbation injecté dans l'étage de résonance 32 par l'étage amplificateur de perturbation 38 écarte l'étage de résonance 32 de sa fréquence d'oscillation nominale ; le signal fourni en sortie par l'étage de résonance 32 est ensuite intégré par l'étage 14 pour générer un signal d'information relié à l'excursion de fréquence induite par le signal de perturbation ; ce signal d'information est comparé dans l'étage 20 avec une valeur seuil ; la présence de la main de la personne est détectée lorsque ce signal d'information présente une relation prédéterminée avec la valeur de seuil susdite et, en particulier, lorsque l'excursion de fréquence induite par le signal de perturbation est supérieure ou égale à un seuil donné. L'étage 26 génère alors sur la sortie 30 un signal en conséquence.

Au contraire, lorsqu'un individu s'écarte de l'antenne 6, on constate qu'aucun signal ne vient plus perturber l'étage de résonance 32. Celui-ci génère alors sur sa propre sortie un signal alterné ayant une fréquence égale à la propre fréquence nominale. Le signal fourni au circuit comparateur 20 est alors tel que le signal sur la sortie 28 adopte un niveau logique bas. Celui-ci est révélateur de ce qu'aucun individu n'est présent à proximité de l'antenne 6

Le signal de présence généré par le circuit comparateur 20 est donc fourni au circuit de sortie 26, lequel, en présentant une configuration inverseuse, génère sur sa propre sortie 30 un signal de commande également de type logique adoptant le niveau logique haut.

Une explication théorique du fonctionnement qui vient d'être décrit et qui a été observé sur les montages proposés par l'invention est la suivante.

L'antenne 6 capte les rayonnements intrinsèques du corps humain, lesquels sont fortement amplifiés par l'étage 38 de l'oscillateur.

Par exemple, au moment où la main d'une personne se trouve à proximité immédiate de la poignée extérieure dans laquelle est logée l'antenne 6, par exemple, entre 3 et 5 cm de celle-ci, le champ électromagnétique intrinsèque rayonné par la main est capté par ladite antenne 6, laquelle génère en sortie un signal de perturbation qui est injecté dans l'étage de résonance 32 par l'étage amplificateur de perturbation 38.

Le signal de perturbation détermine ensuite une variation de la fréquence d'oscillation de l'étage de résonance 32 par rapport à sa valeur nominale et détermine, en particulier, une réduction de la fréquence du signal intermédiaire présent sur la sortie de l'étage de résonance 32.

L'excursion de l'étage de résonance 32 par rapport à sa fréquence d'oscillation nominale détermine une variation du signal d'information présent à la sortie du circuit intégrateur 14 et détermine, en particulier, une réduction de sa fréquence et une réduction de sa valeur moyenne.

En particulier, la valeur moyenne du signal d'information est telle qu'elle modifie la valeur de la tension à l'entrée de l'inverseur logique 60 imposée par le condensateur 64 et, en particulier, est telle qu'elle réduit la valeur de cette tension jusqu'à une valeur inférieure au seuil de commutation de l'inverseur logique 60.

Cette réduction détermine, en conséquence, une commutation du signal de présence généré par le circuit comparateur 20 du niveau logique bas à un niveau logique haut, lequel est, par conséquent, révélateur de la présence de la main de la personne.

Le signal de présence généré par le circuit comparateur 20 est ensuite fourni au circuit de sortie 26, qui génère sur sa propre sortie 30 un signal de commande adoptant le niveau logique bas.

Ce signal est ensuite utilisé dans des systèmes de déverrouillage « mains libres » pour commander l'émission par le véhicule d'un signal radio-fréquence destiné à être reçu par un transpondeur porté par la personne ayant mis la main sur la poignée de la portière et à déclencher l'émission par le transpondeur d'un signal radio-fréquence porteur d'un code permettant à une unité de traitement dans le véhicule d'authentifier ladite personne pour activer les moyens de verrouillage/déverrouillage des portières du véhicule. La détection par le dispositif 1 et les échanges entre le véhicule et le transpondeur se font suffisamment rapidement pour que le déverrouillage des portières intervienne de telle sorte qu'au moment où la personne autorisée à monter dans le véhicule empoigne la poignée de la portière, la serrure de celle-ci soit déjà déverrouillée.

De tels systèmes de déverrouillage « mains libres » d'ouvrants de véhicule sont par exemple du type de ceux décrits dans les demandes de brevets de la demanderesse déposées en France sous les numéros 95 12640 et 96 09166.

D'autres variantes de réalisation de l'invention sont bien entendu possibles.

Le circuit amplificateur 38 et la résistance 36 pourraient être remplacés par tout autre circuit d'amplification permettant un gain tel que la fréquence d'oscillation du signal en sortie des moyens oscillateurs 8 est modifiée lorsque la main d'un individu ou une autre partie de celui-ci se trouve à proximité immédiate de l'antenne 6.

Préférentiellement, ce gain entre la sortie des moyens de réception que constitue l'antenne 6 et l'entrée 34 de l'étage 32 est de l'ordre de ou supérieur à 10⁵, pour au moins une fréquence comprise entre 100 et 500 Hz. Des dispositifs présentant de tels gains ont en effet été testés et donnent entière satisfaction.

Egalement, les moyens de réception peuvent avantageusement comprendre, entre l'antenne 6 et l'entrée 10, un condensateur de 1 nF monté en série avec une résistance de 2,7 MΩ. Cette résistance et ce condensateur permettent de filtrer les perturbations du dispositif de détection par effet capacitif. Ils peuvent également comporter deux diodes reliées chacune à la masse et de sens différents, qui assurent une protection électrostatique du circuit.

Par ailleurs, chaque porte logique 46, 48 et 50 peut être bouclée sur elle-même par l'intermédiaire d'une résistance montée en parallèle par rapport à ladite porte logique. Un montage en boucle de ces différentes portes logiques permet en effet d'augmenter encore le gain en entrée de l'étage de résonance 32.

En outre, il peut être prévu, entre l'entrée de la porte inverseuse 60 et le point commun à la diode 62, au condensateur 64 et à la résistance 66 un montage à seuil adaptatif du type de celui représenté sur la figure 1b.

Un tel montage comporte un comparateur de tension COMP dont une entrée (en l'occurrence l'entrée non inverseuse) est reliée soit directement, soit par l'intermédiaire d'un pont diviseur (non représenté) au point précité commun à la diode 62, au condensateur 64 et à la résistance 66, tandis que son autre entrée (en l'occurrence, l'entrée inverseuse) y est reliée par l'intermédiaire d'un circuit RC.

Du fait du retard introduit par ce circuit RC, la sortie du comparateur COMP n'injectera une tension en entrée de la porte 60 que lorsque la tension au point commun précité variera brusquement.

Les figures 2 à 7 illustrent, à titre d'exemple, les courbes temporelles de quelques signaux du dispositif de détection décrit en référence à la figure 1a.

En particulier, les figures 2 et 3 représentent la courbe temporelle des signaux présents sur la sortie de l'inverseur logique 46 de l'étage amplificateur de perturbation 38 en absence de la main et, respectivement, en présence de la main. Comme on peut le constater, le signal de perturbation injecté dans le circuit oscillateur 8 détermine une réduction de la fréquence de ce signal, ainsi qu'une distorsion de sa forme et une augmentation de l'amplitude pic à pic.

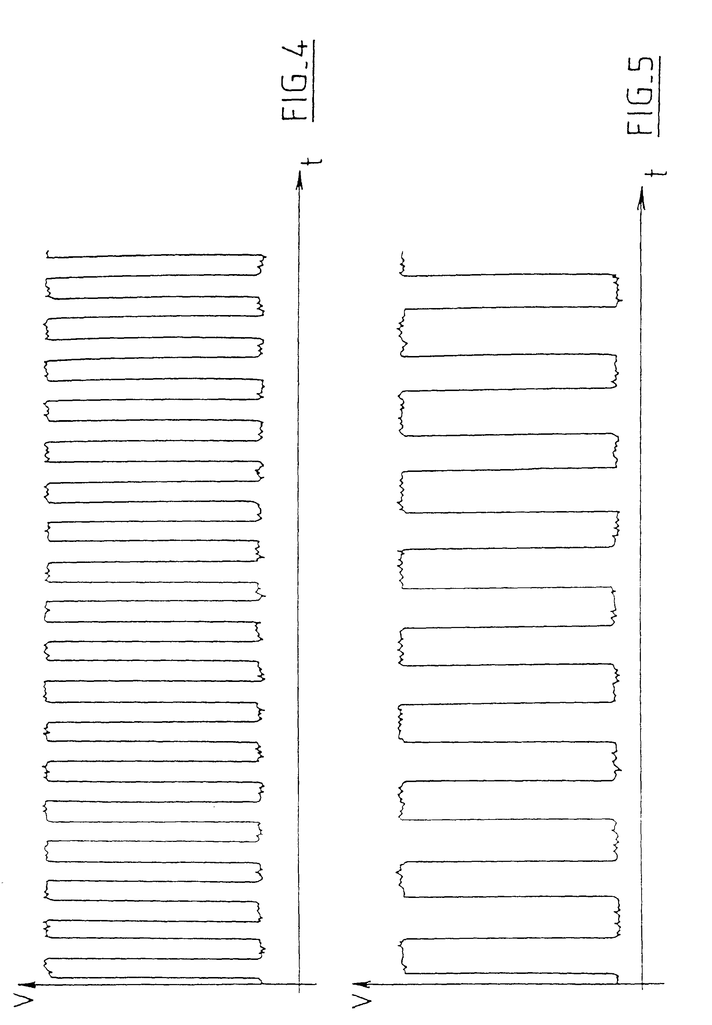

Les figures 4 et 5 représentent, au contraire, la courbe temporelle des signaux présents sur la sortie 12 du circuit oscillateur 8 en absence de la main et, respectivement, en présence de la main et, comme on peut le constater, le signal de perturbation injecté dans le circuit oscillateur 8 détermine une diminution de la fréquence d'oscillation nominale du signal de sortie de l'étage de résonance 32 et sensiblement aucune variation de l'amplitude pic à pic de ce signal.

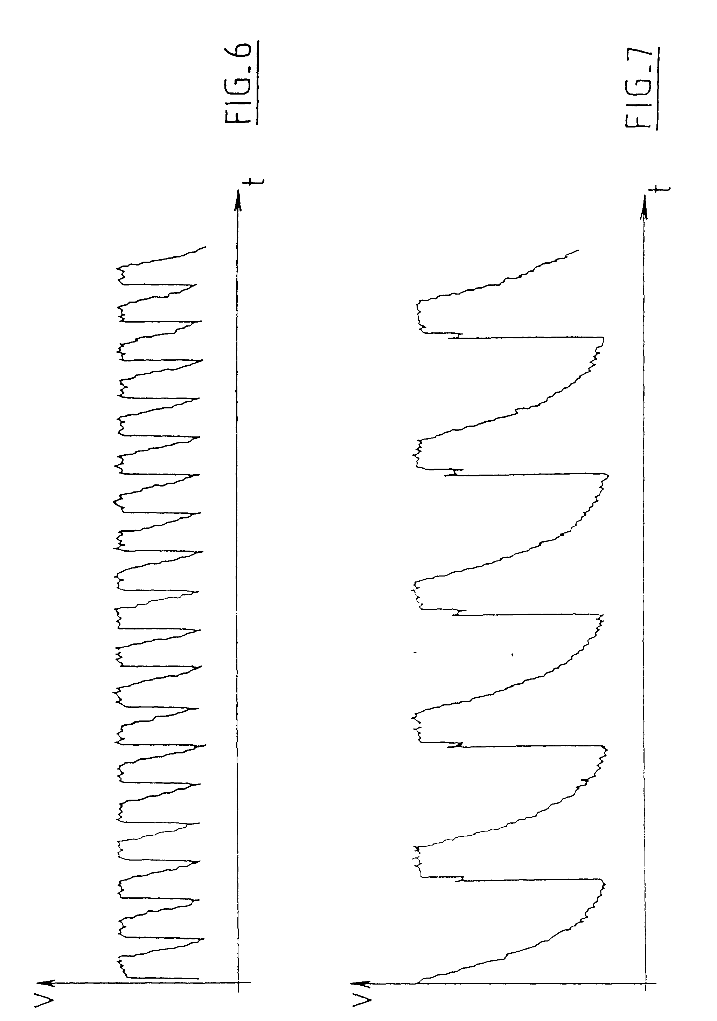

Les figures 6 et 7 illustrent, au contraire, les courbes temporelles des signaux présents à l'entrée de l'inverseur logique 60 du circuit intégrateur 14 en absence de la main et, respectivement, en présence de la main et, comme on peut le constater, la présence du signal de perturbation détermine une réduction de la fréquence du signal présent à l'entrée de l'inverseur logique et une augmentation de l'amplitude pic à pic, ainsi qu'une variation de la forme de ce signal et une réduction de sa valeur moyenne.

Un examen des caractéristiques du dispositif de détection 1 suivant la présente invention met en évidence les avantages que celle-ci permet d'obtenir.

Les circuits sont avant tout simples, présentent des encombrements et des coûts réduits, dans la mesure où le dispositif utilise un nombre limité de composants électroniques couramment disponibles dans le commerce et présentent des consommations de l'ordre de 150 µA, bien inférieures à ceux des dispositifs de détection connus.

De plus, comme décrit précédemment, le dispositif de détection 1 suivant la présente invention permet l'ouverture de la serrure du véhicule de manière automatique à l'approche de la main de la personne de la poignée extérieure du véhicule, et il n'est donc pas forcément nécessaire de doter le véhicule d'une poignée extérieure équipée d'un levier pour l'ouverture manuelle de la serrure, mais il suffit d'utiliser une poignée extérieure de type fixe, avec une réduction consécutive des coûts de fabrication du véhicule même du fait de la simplification de la poignée.

De plus, le dispositif de détection 1 suivant la présente invention peut être utilisé pour la détection du corps humain ou d'une partie de celui-ci pour différentes autres applications, comme, par exemple, le déblocage d'un autre automatisme quelconque du véhicule en présence d'une partie du corps humain, la détection de la présence des mains pour des raisons de prévention des accidents dans les machines-outils (presses, cisailles, etc.), la détection d'une partie du corps humain aux fins de sécurité (contrôle d'un anti-vol du véhicule, d'un anti-vol pour oeuvres d'art, etc.), la détection du corps humain pour le contrôle d'accès, etc.

Il est enfin évident que des modifications et des variantes peuvent être apportées au dispositif et au procédé de détection décrits et illustrés ici, sans pour cela sortir du cadre de protection de la présente invention.

## Revendications

1. Dispositif de détection de présence du type comportant
- des moyens de réception (6) qui comprennent un élément formant antenne,
- des moyens oscillateurs (32, 38) recevant en entrée le signal en sortie desdits moyens de réception, ces moyens oscillateurs (32, 38) comportant un étage de résonance (32) et un étage d'amplification (38) qui est monté en entrée dudit étage de résonance, **caractérisé en ce que** ledit étage d'amplification assure auxdits moyens oscillateurs un gain tel que la fréquence d'oscillation du signal en sortie des moyens oscillateurs (32, 38) est modifiée lorsqu'au moins une partie d'un individu telle que sa main se trouve à proximité immédiate de l'élément formant antenne des moyens de réception, et **en ce que** le dispositif comporte en outre des moyens de traitement (14, 20, 26) pour détecter une variation de la fréquence d'oscillation du signal en sortie des moyens oscillateurs (32) et pour générer un signal d'information caractéristique de la détection d'une présence lorsqu'une telle variation de fréquence est détectée.

2. Dispositif selon la revendication 1, **caractérisé en ce que** l'étage d'amplification (38) assure à l'oscillateur un gain de l'ordre de ou supérieur à 10⁵, pour au moins une fréquence comprise entre 100 et 500 Hz.

3. Dispositif selon l'une des revendications 1 et 2, **caractérisé en ce qu'**une entrée (34) de l'étage amplificateur est reliée à la sortie (7) des moyens de réception (6) par l'intermédiaire de premiers moyens résistifs (36) et **en ce que** l'étage amplificateur comporte au moins une branche qui est montée en parallèle par rapport audits moyens résistifs et qui comprend au moins trois inverseurs logiques en cascade.

4. Dispositif selon la revendication 3, **caractérisé en ce que** les inverseurs logiques sont des amplificateurs formant portes logiques inverseuses, présentant un montage de type « push-pull » en sortie.

5. Dispositif selon l'une des revendications 3 ou 4, **caractérisé en ce que** des deuxièmes moyens résistifs sont montés entre la sortie des moyens de réception et les trois inverseurs logiques en cascade.

6. Dispositif selon l'une des revendications 3 à 5, **caractérisé en ce que** les valeurs de la résistance des premiers moyens résistifs et de la résistance des seconds moyens résistifs sont telles qu'au moins le premier inverseur logique fonctionne en mode non saturé.

7. Dispositif selon la revendication 6, **caractérisé en ce que** le (ou les) inverseur(s) logique(s) non saturé(s) sont suivi(s) par au moins une paire d'inverseurs logiques saturés.

8. Dispositif selon l'une des revendications 3 à 7, **caractérisé en ce que** des moyens résistifs sont montés en parallèle aux bornes de chacun des inverseurs logiques en cascade.

9. Dispositif selon l'une des revendications précédentes, **caractérisé en ce que** les moyens de traitement comportent des moyens comparateurs (20) destinés à comparer à un seuil prédéterminé la valeur moyenne d'un signal caractéristique de la variation de fréquence du signal en sortie de l'étage amplificateur.

10. Dispositif de détection selon l'une des revendications précédentes, **caractérisé par le fait que** l'étage de résonance (32) comprend des moyens inverseurs logiques (40) placés entre l'entrée (34) et la sortie (12) desdits moyens oscillateurs (32), ainsi que des moyens capacitifs (42) et résistifs (44) montés en série entre la sortie (7) desdits moyens de réception (6) et la sortie (12) de l'étage amplificateur (32).

11. Dispositif de détection selon l'une des revendications précédentes, **caractérisé par le fait que** les moyens de traitement comprennent des moyens intégrateurs (14) montés en sortie (12) de l'étage amplificateur (32).

12. Dispositif de détection selon la revendication 11, **caractérisé par le fait que** lesdits moyens intégrateurs (14) comprennent des moyens inverseurs logiques (54) ayant une entrée reliée à l'entrée desdits moyens intégrateurs (14) par l'intermédiaire de moyens interrupteurs unipolaires (56), ainsi que des moyens capacitifs (57) montés entre l'entrée desdits moyens inverseurs logiques (54) et une ligne de masse (4).

13. Dispositif selon la revendication 12, **caractérisé par le fait que** lesdits moyens intégrateurs (14) comprennent, de plus, des moyens résistifs (58) de type variable placés entre l'entrée desdits cinquièmes moyens inverseurs logiques (54) et ladite ligne de masse (4).

14. Dispositif selon la revendication 9, **caractérisé par le fait que** les moyens comparateurs (20) comprennent des moyens inverseurs logiques (60) ayant une entrée reliée à l'entrée (22) desdits moyens comparateurs (20) à travers de moyens interrupteurs unipolaires (62), des moyens capacitifs (64) montés entre une ligne d'alimentation (2) et l'entrée desdits moyens inverseurs logiques (60) ; des moyens résistifs (66) montés en série avec des moyens interrupteurs unipolaires (68) entre l'entrée desdits moyens inverseurs logiques (60) et la ligne de masse (4).

15. Dispositif selon la revendication 9 ou la revendication 14, **caractérisé en ce que** les moyens comparateurs (20) comportent un montage comparateur à seuil adaptatif (R, C, COMP).

16. Dispositif selon l'une des revendications précédentes, **caractérisé en ce que** les moyens de réception comportent des moyens pour le filtrage des perturbations dues à des effets capacitifs.

17. Système de déverrouillage d'ouvrants de véhicule, notamment automobile, de type « mains libres », comportant un dispositif de détection de présence et des moyens pour l'émission d'un signal d'interrogation qui sont réveillés lorsque le dispositif détecte la présence d'un individu, **caractérisé en ce que** ledit dispositif est un dispositif de détection de présence selon l'une des revendications précédentes.

## Patentansprüche

1. Vorrichtung zur Anwesenheitserfassung, **gekennzeichnet durch:**
- Empfangsmittel (6), die ein eine Antenne bildendes Element enthalten,
- Oszillatormittel (32, 38), auf deren Eingang das an dem Ausgang der besagten Empfangsmittel liegende Signal übertragen wird, wobei diese Oszillatormittel (32, 38) eine Resonatorstufe (32) und eine Verstärkerstufe (38) umfassen, welche am Eingang der besagten Resonatorstufe angeordnet ist und die sicherstellt, daß die Oszillatormittel eine Verstärkung aufweisen, derart, daß die Schwingungsfrequenz des Signales am Ausgang der Oszillatormittel (32, 38) verändert wird, wenn wenigstens ein Teil einer Person, wie seine Hand, sich in der unmittelbaren Nähe des die Antenne bildenden Elementes der Empfangsmittel befindet,
- Verarbeitungsmittel (14, 20, 26), um eine Veränderung der Schwingungsfrequenz des Signales am Ausgang der Oszillatormittel (32) zu ermitteln und um ein Informationssignal zu erzeugen, welches bei Auftreten einer derartigen Frequenzänderung für die Anwesenheitserfassung charakteristisch ist.

2. Vorrichtung nach Anspruch 1, **dadurch gekennzeichnet, daß** die Verstärkerstufe (38) eine Verstärkung des Oszillators in der Größenordnung oder oberhalb 10⁵ für wenigstens eine Frequenz zwischen 100 und 500 Hz sicherstellt.

3. Vorrichtung nach einem der Ansprüche 1 und 2, **dadurch gekennzeichnet, daß** ein Eingang (34) der Verstärkerstufe über erste Widerstandsmittel (36) mit dem Ausgang (7) der Empfangsmittel (6) verbunden ist, und daß die Verstärkerstufe wenigstens einen parallel in bezug auf die besagten Widerstandsmittel angeordneten elektrischen Zweig umfaßt, der wenigstens drei kaskadenförmig geschaltete logische Inverter umfaßt.

4. Vorrichtung nach Anspruch 3, **dadurch gekennzeichnet, daß** es sich bei den logischen Invertern um Verstärker handelt, welche invertierende logische Tore bilden, die ausgangsseitig eine Gegentakt-anordnung (push-pull) bilden.

5. Vorrichtung nach einem der Ansprüche 3 oder 4, **dadurch gekennzeichnet, daß** zweite Widerstandsmittel zwischen dem Ausgang der Empfangsmittel und den drei kaskadenförmig angeordneten logischen Invertern angeordnet sind.

6. Vorrichtung nach einem der Widerstände 3 bis 5, **dadurch gekennzeichnet, daß** die Widerstandswerte der ersten und zweiten Widerstandsmittel derart gewählt sind, daß mindestens der erste logische Inverter nicht in einem Modus der Sättigung arbeitet.

7. Vorrichtung nach Anspruch 6, **dadurch gekennzeichnet, daß** dem (oder den) nicht im Sättigungsbereich arbeitenden logischen Inverter mindestens ein Paar gesättigter logischer Inverter nachgeschaltet ist (sind).

8. Vorrichtung nach einem der Ansprüche 3 bis 7, **dadurch gekennzeichnet, daß** Widerstandsmittel parallel zu den Klemmen jedes der kaskadenförmig-angeordneten logischen Invertern vorgesehen sind.

9. Vorrichtung nach einem der vorhergehenden Ansprüche, **dadurch gekennzeichnet, daß** die Verarbeitungsmittel Komparatoren (20) umfassen, mit denen der Mittelwert eines für die Veränderung der Frequenz des am Ausgang der Verstärkerstufe sich ergebenden charakteristischen Signale mit einem vorgegebenen Schwellwert verglichen wird.

10. Empfangsvorrichtung nach einem der vorhergehenden Ansprüche, **dadurch gekennzeichnet, daß** die Resonatorstufe (32) logische Invertermittel (40) umfaßt, die zwischen dem Eingang (34) und dem Ausgang (12) der Oszillatormittel (32) angeordnet sind, wie auch in Serie geschaltete kapazitive Mittel (42) und Widerstandsmittel (44), die zwischen dem Ausgang (7) der Empfangsmittel (6) und dem Ausgang (12) der Verstärkerstufe (32) angeordnet sind.

11. Empfangsvorrichtung nach einem der vorhergehenden Ansprüche, **dadurch gekennzeichnet, daß** die Verarbeitungsmittel am Ausgang (12) der Verstärkerstufe (32) angeordnete Integratormittel (14) umfassen.

12. Empfangsvorrichtung nach Anspruch 11, **dadurch gekennzeichnet, daß** die Integratormittel (14) logische Invertermittel (54) umfassen, mit einem Eingang, der über Mittel eines einpoligen Schalters (56) mit den Integratormitteln (14) verbunden ist, wie auch kapazitive Mittel (57), welche zwischen dem Eingang der besagten logischen Inverter (54) und einer Erdleitung (4) angeordnet sind.

13. Vorrichtung nach Anspruch 12, **dadurch gekennzeichnet, daß** die Mittel des Integrators (14) außerdem variable Widerstandsmittel (58) umfassen, die zwischen dem Eingang der besagten fünften logischen Invertermittel (54) und der Erdleitung (4) angeordnet sind.

14. Vorrichtung nach Anspruch 9, **dadurch gekennzeichnet, daß** die Mittel der Komparatoren (20) logische Invertermittel (60) umfassen, welche einen Eingang besitzen, der über Mittel des einpoligen Schalters (62) mit dem Eingang (22) der Mittel der Komparatoren (20) verbunden ist, wobei kapazitive Mittel (64) zwischen einer Stromzuleitung (2) und dem Eingang der logischen Invertermittel (60) angeordnet sind; und wobei in Serie mit Mitteln eines einpoligen Schalters (68) geschaltete Widerstandsmittel (66) zwischen dem Eingang der besagten logischen Invertermittel (60) und der Erdleitung angeordnet sind.

15. Vorrichtung nach Anspruch 9 oder 14, **dadurch gekennzeichnet, daß** die Mittel der Komparatoren (20) eine Komparatoranordnung mit einer adaptiven Schwelle (R, C, COMP) umfassen.

16. Vorrichtung nach einem der vorhergehenden Ansprüche, **dadurch gekennzeichnet, daß** die Empfangsmittel Mittel mit kapazitiver Wirkung zur Filterung der Störungen enthalten.

17. Entriegelungssystem einer zu öffnenden Fahrzeugeinrichtung, insbesondere eines Kraftfahrzeuges mit einem "Freie Hände"-System, welches eine Vorrichtung zur Anwesenheitserfassung und Mittel zur Aussendung eines Abfragesignales umfaßt, die aktiviert werden, wenn die Vorrichtung die Anwesenheit einer Person erfaßt, **dadurch gekennzeichnet, daß** es sich bei der besagten Vorrichtung um eine Vorrichtung zur Anwesenheitserfassung gemäß einem der vorhergehenden Ansprüche handelt.

## Claims

1. Presence-detection device, **characterised in that** it includes:
- receiving means (6) which comprise an antenna-forming element,
- oscillator means (32, 38) receiving, as input, the signal leaving the said receiving means, these oscillator means (32, 38) including a resonance stage (32) and an amplification stage (38) which is mounted at the input of the said resonance stage and which provides the said oscillator means with a gain such that the oscillation frequency of the signal leaving the oscillator means (32, 38) is altered when at least a part of an individual, such as his hand, lies in immediate proximity to the antenna-forming element of the receiving means,
- processing means (14, 20, 26) for detecting a variation in the oscillation frequency of the signal leaving the oscillator means (32) and for generating an information signal characteristic of the detection of a presence when such a frequency variation is detected.

2. Device according to Claim 1, **characterised in that** the amplification stage (38) provides the oscillator with a gain of the order of or greater than 10⁵, for at least one frequency lying between 100 and 500 Hz.

3. Device according to one of Claims 1 and 2, **characterised in that** one input (34) of the amplifier stage is linked to the output (7) of the receiving means (6) by way of first resistive means (36), and **in that** the amplifier stage includes at least one branch which is mounted in parallel with respect to the said resistive means and which comprises at least three logic inverters in cascade.

4. Device according to Claim 3, **characterised in that** the logic inverters are amplifiers forming inverting logic gates, featuring a layout of push-pull type as output.

5. Device according to one of Claims 3 and 4, **characterised in that** second resistive means are mounted between the output of the receiving means and the three logic inverters in cascade.

6. Device according to one of Claims 3 to 5, **characterised in that** the values of the resistance of the first resistive means and of the resistance of the second resistive means are such that at least the first logic inverter functions in non-saturated mode.

7. Device according to Claim 6, **characterised in that** the non-saturated logic inverter(s) is or are followed by at least one pair of saturated logic inverters.

8. Device according to one of Claims 3 to 7, **characterised in that** resistive means are mounted in parallel at the terminals of each of the logic inverters in cascade.

9. Device according to one of the preceding claims, **characterised in that** the processing means include comparator means (20) intended for comparing, with a predetermined threshold, the average value of a signal characteristic of the frequency variation of the signal leaving the amplifier stage.

10. Detection device according to one of the preceding claims, **characterised in that** the resonance stage (32) comprises logic-inverter means (40) placed between the input (34) and the output (12) of the said oscillator means (32), as well as capacitive (42) and resistive (44) means mounted in series between the output (7) of the said receiving means (6) and the output (12) of the amplifier stage (32).

11. Detection device according to one of the preceding claims, **characterised in that** the processing means comprise integrator means (14) mounted at the output (12) of the amplifier stage (32).

12. Detection device according to Claim 11, **characterised in that** the said integrator means (14) comprise logic-inverter means (54) having one input linked to the input of the said integrator means (14) by way of single-pole switch means (56), as well as capacitive means (57) mounted between the input of the said logic-inverter means (54) and an earth line (4).

13. Device according to Claim 12, **characterised in that** the said integrator means (14) further comprise resistive means (58) of variable type placed between the input of the said fifth logic-inverter means (54) and the said earth line (4).

14. Device according to Claim 9, **characterised in that** the comparator means (20) comprise logic-inverter means (60) having one input linked to the input (22) of the said comparator means (20) via single-pole switch means (62), capacitive means (64) mounted between a power-supply line (2) and the input of the said logic-inverter means (60), resistive means (66) mounted in series with single-pole switch means (68) between the input of the said logic-inverter means (60) and the earth line (4).

15. Device according to Claim 9 or Claim 14, **characterised in that** the comparator means (20) include an adaptive-threshold comparator layout (R, C, COMA).

16. Device according to one of the preceding claims, **characterised in that** the receiving means include means for filtering disturbances due to capacitive effects.

17. System for unlocking vehicle doors, especially motor-vehicle doors, of the "hands free" type, including a presence-detection device and means for sending out an interrogation signal which are awakened when the device detects the presence of an individual, **characterised in that** the said device is a presence-detection device according to one of the preceding claims.
